# EUROPÄISCHE PATENTANMELDUNG

(11) **EP 0 903 788 A2**
(43) Veröffentlichungstag der Anmeldung: **24.03.1999**
(21) Anmeldenummer: 98113536.1
(22) Anmeldetag: 17.07.1998
(51) Int. Cl.: H01L 29/788, H01L 21/336, H01L 29/423

(54) **Nichtflüchtige Speicherzelle mit hoher Koppelkapazität**

(30) Priorität: 30.07.1997 DE 19732870
(71) Anmelder: SIEMENS AKTIENGESELLSCHAFT, 80333 München (DE)
(72) Erfinder: Graf von Schwerin, Alexander, Dr., 81539 München (DE); Dietz, Guido Wolfgang, Dr., 85549 Haar (DE)

(57) **Zusammenfassung**

Bei einer nichtflüchtigen Speicherzelle mit einem Floatinggate (EEPROM) muß eine große Koppelkapazität zwischen Floatinggate und Controlgate bei geringem Platzbedarf erzielt werden. Dazu ist vorgesehen, daß das Dielektrikum zwischen Floatinggate und Controlgate abschnittsweise in etwa senkrecht zur Substratoberfläche verläuft, beispielsweise indem das Controlgate innerhalb eines U- oder topfförmigen Floatinggates angeordnet ist.

## Beschreibung

Die Erfindung betrifft eine Halbleiterstruktur nach dem Oberbegriff des Patentanspruchs 1. Eine derartige Halbleiterstruktur stellt einen nichtflüchtigen Speicher dar, eine sogenannte EEPROM-Zelle.

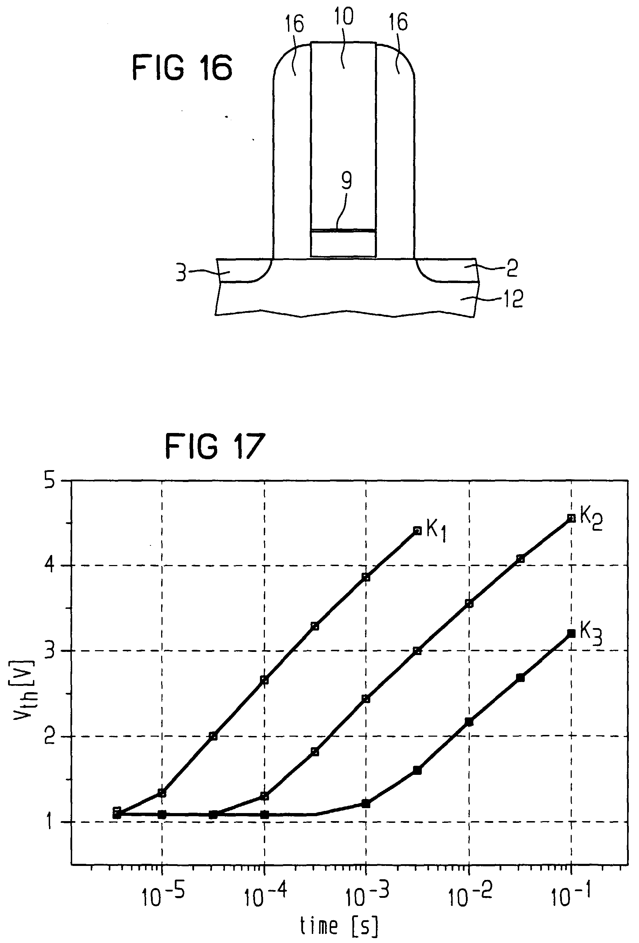

Die Programmierung (d.h. Schreiben und Löschen) einer derartigen Speicherzelle erfolgt durch Anlegen eines Potentials an das nach außen angeschlossene Controlgate, das kapazitiv mit dem nicht angeschlossenen Floatinggate gekoppelt ist. Für eine kurze Programmierzeit ist eine große kapazitive Kopplung zwischen Floatinggate und Controlgate notwendig. In FIG 17 ist die zeitliche Änderung der Einsatzspannung beim Löschen für drei verschiedene Speicherzellen mit drei verschiedenen Koppelkonstanten K₁, K₂, K₃ dargestellt, wobei K₁ > K₂ > K₃ ist. Erkennbar führt die größere Kapazität K₁ zu einer schnelleren Änderungen der Einsatzspannung Vₜₕ, diese Zelle ist also schneller gelöscht.

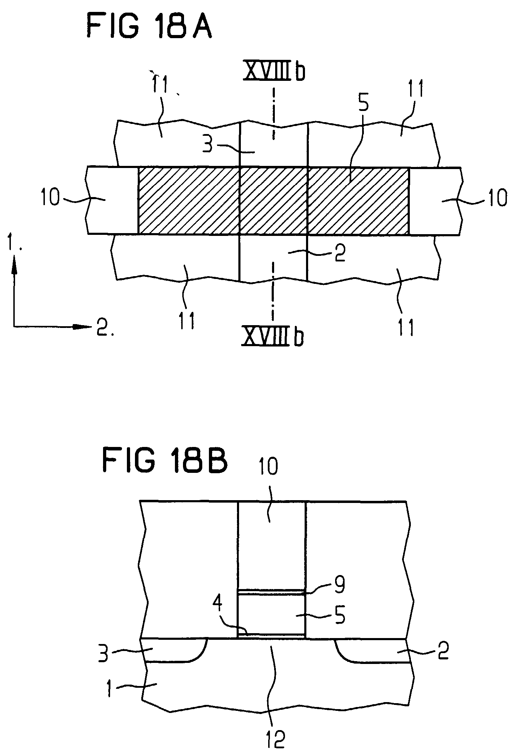

Die Realisierung einer großen Kapazität zwischen Floating-Gate und Controlgate ist bei den bekannten Zellkonzepten, bei denen das Controlgate planar auf dem Floatinggate angeordnet ist, mit einem großen Platzbedarf verbunden. Eine ausreichend große Koppelkapazität wird dadurch erreicht, daß die laterale Ausdehnung des Floatinggates weitaus größer ist als die Ausdehnung des aktiven Gebietes (d.h. der dotierten Gebiete und des dazwischenliegenden Kanalbereichs) der Zelle. In FIG 18a ist eine Aufsicht auf eine konventionelle Zelle gezeigt. Das Floatinggate 5 verläuft quer zu einer ersten Richtung, die durch die Verbindungslinie zwischen den dotierten Gebieten 2, 3 definiert ist, und erstreckt sich in dieser zweiten Richtung über ein das aktive Gebiet umgebendes Isolationsgebiet 11. Die Ausdehnung des Floatinggates ist schraffiert dargestellt. Das Controlgate 10 verläuft in der zweiten Richtung über dem Floatinggate. FIG 18b zeigt die Anordnung in einem Querschnitt durch das aktive Gebiet des Halbleitersubstrats 1 entlang der ersten Richtung. Floatinggate 5 und Controlgate 10 sind durch ein Dielektrikum 9 voneinander getrennt, das parallel zur Substratoberfläche verläuft. Ein typischer Kapazitätswert in einer 0,6 µ-Technologie liegt bei etwa 1,9 fF. Die dafür benötigte Fläche ist typischerweise etwa drei mal so groß wie der Kanalbereich, dadurch wird die Integrationsdichte in einer Speicheranordnung, die eine Vielzahl derartiger benachbarter Speicherzellen aufweist, begrenzt.

Aufgabe der Erfindung ist es, eine Halbleiterstruktur der genannten Art anzugeben, die einen verringerten Platzbedarf aufweist, ohne daß die Koppelkapazität zwischen Floatinggate und Controlgate verringert wird. Eine weitere Aufgabe ist die Angabe eines Herstellverfahrens für eine derartige Halbleiterstruktur.

Diese Aufgabe wird durch eine Halbleiterstruktur mit den Merkmalen des Patentanspruchs 1 und durch ein Herstellverfahren mit den Merkmalen des Patentanspruchs 9 gelöst.

Grundgedanke der Erfindung ist es, Floatinggate und Controlgate nicht planar übereinander anzuordnen, sondern ineinander zu falten. Das sie trennende Dielektrikum und die diesem Dielektrikum zugewandten, kapazitätswirksamen Oberflächen von Floatinggate und Controlgate liegen dann nicht ausschließlich in einer zur Substratoberfläche parallelen Ebene, sondern weisen zumindest einen Abschnitt auf, in dem sie mit der Oberfläche einen Winkel bilden. Dieser Winkel ist annähernd 90°, um eine möglichst effektive Faltung, d.h. eine möglichst große kapazitätswirksame Oberfläche relativ zur beanspruchten Grundfläche zu erzielen.

In einer bevorzugten Ausführungsform wird das Floatinggate an zwei in der ersten Richtung gegenüberliegenden Seiten - den Source und Drain zugewandten Seiten - nach oben gefaltet, so daß es einen U-förmigen Querschnitt aufweist. Die Innenwände dieses 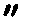 U" sind mit dem Dielektrikum ausgekleidet. Das Controlgate verläuft innerhalb, vorzugsweise vollständig innerhalb, des in dem durch das Floatinggate gebildeten Grabens. Die Kapazität setzt sich aus den Beiträgen des Bodens und der Seitenwände zusammen und kann daher durch Vergrößerung der Seitenwände nach oben vergrößert werden, ohne daß eine größere Grundfläche beansprucht wird. Die Floatinggates benachbarter Zellen sind durch eine erste isolierende Schicht getrennt, deren Dicke vorzugsweise der Gesamthöhe des Floatinggates entspricht. Über dem an den Kanalbereich in der zweiten Richtung angrenzenden Isolationsgebiet weist die erste isolierende Schicht einen Graben auf, der an den vom Floatinggate gebildeten Graben anschließt. Das Controlgate kann dann innerhalb des Grabens verlaufen.

In einer zweiten Ausführungsform wird das Floatinggate an allen Seiten nach oben gefaltet, so daß es topfförmig ausgebildet ist. Die Innenwände des Topfes sind mit dem Dielektrikum ausgekleidet. Das Controlgate verläuft über die Oberkante des Floatinggates hinweg und ragt in das Innere des Topfes hinein. Dabei kann der den Topf auffüllende Teil des Controlgates aus einem anderen Material bestehen als der darüberlaufende Teil, oder es können beide Teile aus dem gleichen Material, evt. gleichzeitig, hergestellt werden.

Die kapazitätswirksamen Oberflächen können auch mehrfach gefaltet sein, so daß das Floatinggate topfförmig oder U-förmig mit innenliegenden, sich nach oben erstreckenden Lamellen ausgebildet ist und einen kammförmigen Querschnitt besitzt. Derartige Lamellen lassen sich in bekannter Weise als Spacer herstellen.

Es muß vermieden werden, daß das Controlgate direkt oder lediglich durch das Dielektrikum getrennt über dem Kanalbereich verläuft. Bspw. bei der ersten Ausführungsform kann dies dadurch erreicht werden, daß das Floatinggate den Kanalbereich sicher bedeckt, also insbesondere in der zweiten Richtung bis zur Grenze zwischen Kanalbereich und Isolationsgebiet reicht. Dann ist das Controlgate durch das Floatinggate und das Dielektrikum vom Kanalbereich getrennt. Zur Minimierung des Platzbedarfs ist es andererseits wünschenswert, daß das Floatinggate das Isolationsgebiet höchstens gering überdeckt und der Abstand zu dem in der zweiten Richtung benachbarten Floatinggate minimiert wird. Wird das Floatinggate durch eine Lithographie erzeugt, ist seine minimale Breite durch die erzielbare Strukturfeinheit F vorgegeben. Der einzukalkulierende Justierfehler beträgt üblicherweise F/3. Die vollständige Bedeckung des Kanalbereichsdurch das Floatinggate kann dadurch sichergestellt werden, daß die Ausdehnung des Floatinggates in der zweiten Richtung 5/3 F und der Abstand zwischen benachbarten Floatinggates F beträgt, so daß das Raster in dieser Richtung 2 2/3 F beträgt.

Zur Herstellung der Struktur ist vorgesehen, auf einem zumindest mit einem Gatedielektrikum und mit einem Isolationsgebiet, das das dotierte Gebiet freiläßt, versehenen Substrat eine erste leitende Schicht aufzubringen und mit Hilfe einer ersten Maske lithographisch zu strukturieren. Die erste leitende Schicht kann entweder zu einer Bahn strukturiert werden, die in der zweiten Richtung über das aktive Gebiet, nämlich über den Kanalbereich, und das angrenzende Isolationsgebiet verläuft bzw. bei einer Vielzahl von zu bildenden Zellen über die in der zweiten Richtung benachbarten Kanalbereiche verläuft. Die erste leitende Schicht kann aber auch bereits entsprechend den lateralen Ausmaßen des Floatinggates strukturiert werden (zweite Ausführungsform), so daß sie nicht durchgängig über benachbarte Zellen verläuft. Die Ausmaße sind vorzugsweise F X F.

Die zur Strukturierung eingesetzte erste Maske ist vorzugsweise eine Hartmaske beispielsweise aus Siliziumnitrid oder Siliziumoxid. Sie verbleibt zunächst auf der Anordnung und muß daher mit den folgenden Prozeßschritten kompatibel sein.

Die Dicke der Maske bestimmt die maximal mögliche Höhe der Seitenwände des Floatinggates.

Es wird eine erste isolierende Schicht aufgebracht, vorzugsweise ganzflächig mit anschließender Planarisierung, so daß die Oberfläche der ersten Maske freigelegt wird und vorzugsweise in einer Ebene mit der Oberfläche der ersten isolierenden Schicht liegt. Die erste isolierende Schicht muß aus einem anderen Material als die erste Maske bestehen, beispielsweise aus Siliziumoxid oder Siliziumnitrid. Die erste Maske wird entfernt, so daß ein graben- oder topfförmiges Loch in der isolierenden Schicht entsteht, dessen Seitenwände von der ersten isolierenden Schicht und dessen Boden von der ersten leitenden Schicht gebildet werden.

Es wird eine zweite leitende Schicht mindestens auf den Seitenwänden des Lochs aufgebracht, beispielsweise ganzflächig abgeschieden und rückgeätzt. Die zweite leitende Schicht füllt das Loch nicht auf und besteht vorzugsweise aus demselben Material wie die erste leitende Schicht.

Bei einer grabenförmigen Ausbildung des Lochs müssen mit Hilfe einer zweiten Maske die erste und zweite leitende Schicht geätzt werden, um in der zweiten Richtung benachbarte Floatinggates voneinander zu trennen. Vorzugsweise erfolgt die Ätzung so, daß die leitenden Schichten den Kanalbereich sicher bedecken, andernfalls muß der freigelegte Kanalbereich in geeigneter Weise isoliert werden. Die zweite Maske und der Ätzprozeß sind nicht notwendig, wenn die erste leitende Schicht und damit das Loch bereits die Ausmaße des herzustellenden Floatinggates aufweisen. Da in diesem Fall das Loch allseits von der ersten isolierenden Schicht umgeben ist, kann das Controlgate nicht lediglich durch das Dielektrikum getrennt über dem Kanalbereich verlaufen. Das Floatinggate kann daher F x F groß sein.

Auf diese Weise ist ein Floatinggate mit U- oder topfförmigem Querschnitt erzeugt. Soll das Floatinggate mit einem kammförmigen Querschnitt gebildet werden, werden abwechselnd isolierende und leitende Spacer an den Lochwänden erzeugt, und die isolierenden Spacer wieder entfernt.

Die Innenwand wird mit einem Dielektrikum bedeckt, beispielsweise durch ganzflächiges Aufbringen einer ONO-Schicht. Schließlich wird das verbleibende Loch mit einer dritten leitenden Schicht aufgefüllt, die das Controlgate bildet. Bei einem U-förmigen Floatinggate in einem Graben, der sich über den in zweiter Richtung benachbarten Isolationsgebiet in der ersten isolierenden Schicht fortsetzt, kann das Controlgate völlig innerhalb des Grabens verlaufen. Bei einem topfförmigen Floatinggate erstreckt sich ein Teil des Controlgates in das Loch, benachbarte Floatinggates werden durch einen über den Floatinggate-Rand verlaufenden Teil des Controlgates miteinander verbunden. Die beiden Teile des Controlgates können gleichzeitig oder getrennt, auch aus verschiedenem Material hergestellt werden.

Die dotierten Gebiete Source und Drain können entweder zu Beginn des Prozesses hergestellt werden, oder nach der Ätzung der ersten leitenden Schicht. Dazu werden an den Seitenwänden der ersten Maske und der ersten leitenden Schicht Spacer vorzugsweise aus demselben Material wie die erste isolierende Schicht hergestellt, anschließend werden die Gebiete implantiert. Weiter wird wie oben beschrieben verfahren.

In einer dritten Ausführungsform besitzt die Halbleiterstruktur ein U-förmiges Floatinggate, wobei die Seitenwände an den in der zweiten Richtung gegenüberliegenden Rändern des Floatinggates nach oben gefaltet werden. Der vom Floatinggate gebildete Graben verläuft dann in der ersten Richtung, und das in der zweiten Richtung verlaufende Controlgate muß über die Seitenwände des Floatinggates hinweggeführt werden. Bei der Herstellung des Floatinggates wird vorzugsweise die erste leitende Schicht zunächst mit der ersten Maske einer in der ersten Richtung über das aktive Gebiet verlaufenden Bahn strukturiert, wobei das Isolationsgebiet im wesentlichen frei bleibt. Die Bildung der Seitenwände erfolgt wie oben beschrieben. Die dritte leitende Schicht wird ganzflächig aufgebracht und mit einer weiteren Maske zu den in der zweiten Richtung verlaufenden Controlgate strukturiert. Unter Verwendung derselben Maske werden das unterliegende Dlelektrikum und die erste leitende Schicht geätzt, so daß im aktiven Gebiet die zu dotierenden Source- und Draingebiete freiliegen. Nach der Herstellung von isolierenden Spacern an den Seitenwänden der so erzeugten Struktur werden Source und Drain implantiert.

Bei dieser Ausführungsform kann das Floatinggate auch bei Berücksichtigung von Justierfehlern in der ersten und der zweiten Richtung jeweils das Ausmaß F besitzen. Bei einem Versatz der ersten Maske in der zweiten Richtung überlappt das Floatinggate auf der einen Seite das Isolationsgebiet und bedeckt auf der anderen Seite den Kanalbereich nicht vollständig. Dieser freigelegte Kanalbereich wird jedoch - wie bei der zweiten Ausführungsform - später von der ersten Isolationsschicht bedeckt, so daß die elektrische Funktion der Zelle nicht beeinträchtigt wird. Ein Versatz der Maske zur Definition des Controlgates ist ebenfalls unkritisch, da mit dieser sowohl Floatinggate und Controlgate gleichzeitig als auch Source und Drain definiert werden.

Bei der erfindungsgemäßen Zelle kann die Koppelkapazität durch die Höhe der Seitenwände genau eingestellt werden, ohne daß die Grundfläche der Zelle geändert werden muß. Die zur Verfügung stehende Grundfläche ist bei einer EPROM-Zelle sehr eingeschränkt, da die dotierten Gebiete nicht überdeckt werden können. Ferner muß berücksichtigt werden, daß die Dimension des Floatinggates sowohl die Transistoreigenschaften als auch die Kondensatoreigenschaften beeinflußt. Die erfindungsgemäße Zelle ermöglicht unter Berücksichtigung dieser Randbedingungen eine hohe Integrationsdichte.

Die Erfindung wird im folgenden anhand von Ausführungsbeispielen, die in den Figuren dargestellt sind, näher erläutert. Es zeigen
FIG 1 und 2 eine Aufsicht auf die erfindungsgemäße Halbleiterstruktur gemäß einer ersten bzw. einer zweiten Ausführungsform
FIG 3 bis 9 einen Querschnitt durch das Halbleitersubstrat in der ersten Richtung, an dem die Schritte des Herstellverfahrens für die erste Ausführungsform (FIG 3 bis 8) und die zweite Ausführungsform (FIG 3 bis 7, 9) verdeutlicht werden,
FIG 10 eine Aufsicht auf die erfindungsgemäße Halbleiterstruktur gemäß einer dritten Ausführungsform
FIG 11 bis 16 Querschnitte durch das Halbleitersubstrat in der ersten (a) und in der zweiten Richtung (b), an dem die Schritte des Herstellverfahrens für die dritte Ausführungsform verdeutlicht werden,
FIG 17 die zeitliche Änderung der Einsatzspannung beim Löschvorgang für drei EPROM-Zellen mit Koppelkapazitäten K₁ > K₂ > K₃,
FIG 18 Aufsicht (a) und Schnitt (b) durch eine konventionelle EEPROM-Zelle.

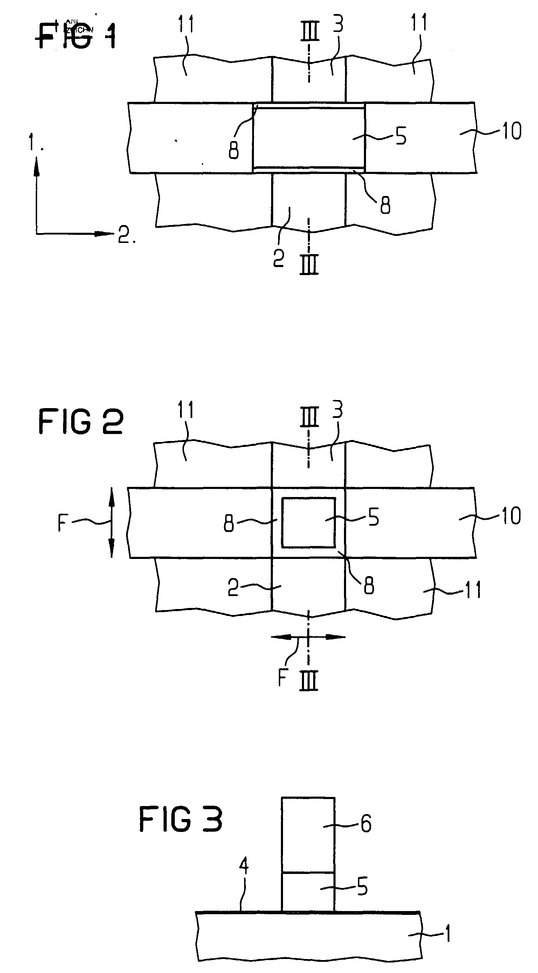

FIG 1: Die Aufsicht auf ein Halbleitersubstrat 1 zeigt ein durch Source 2, Drain 3 und den dazwischenliegenden Kanalbereich (12) definiertes aktives Gebiet einer EEPROM-Zelle, das von einem Isolationsgebiet 11 umgeben ist. Die Verbindungslinie zwischen Source und Drain definiert eine erste Richtung. Der Kanalbereich ist von einem Floatinggate 5 überdeckt, das an den in der ersten Richtung gegenüberliegenden Seiten nach oben gefaltet ist, so daß es sich nach oben erstreckende Seitenwände 8 aufweist. Über dieser Anordnung verläuft quer zur ersten Richtung ein bahnförmiges Controlgate 10, das isoliert auf dem Floatinggate 5, 8 aufgebracht ist. Die durch das Controlgate 10 definierte zweite Richtung ist insbesondere rechtwinklig zur ersten Richtung. Mögliche Justierfehler werden bei der Zelle dadurch berücksichtigt, daß das Floatinggate 5, 8 in der zweiten Richtung ein Ausmaß von 5/3 F besitzt. Dann ist auch bei einer maximal anzunehmenden Dejustierung von 1/3 F gewährleistet, daß das Controlgate 10 nicht nur vom Dielektrikum getrennt auf dem aktiven Gebiet aufliegt, sondern dort auf dem Floatinggate angeordnet ist. Die Aufsicht soll lediglich die Lage des aktiven Gebiets, des Isolationsgebietes und von Floatinggate und Controlgate verdeutlichen, so daß nur diese Elemente dargestellt sind.

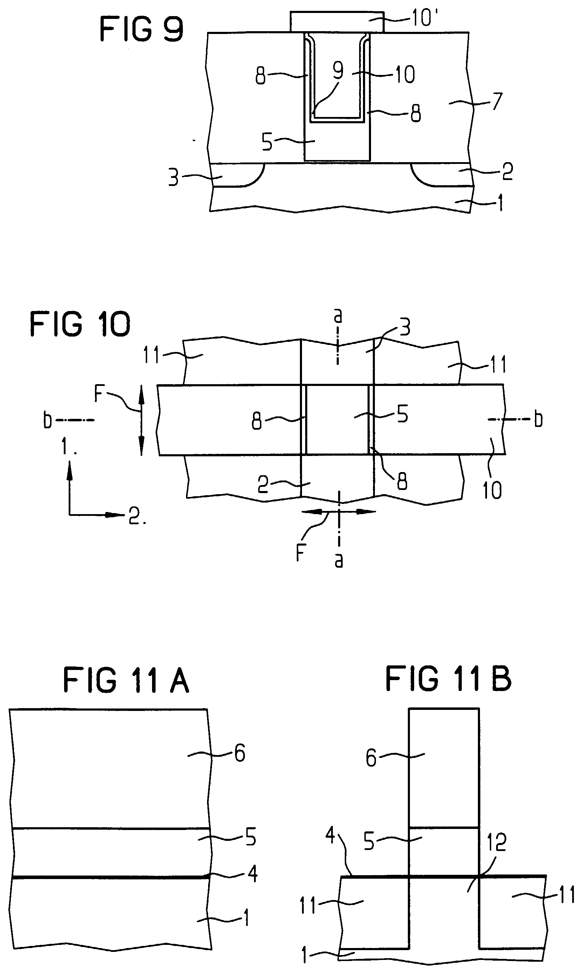

FIG 2: Gemäß der zweiten Ausführungsform besitzt die Zelle ein topfförmiges Floatinggate, bei dem an allen Seiten die Seitenwände 8 nach oben gezogen sind. Die Ausdehnung des Floatinggates in der zweiten Richtung kann F betragen, da - auch bei einem Versatz gegenüber dem aktiven Gebiet - das Controlgate außerhalb des Topfinneren auf der ersten Isolationsschicht aufliegt (siehe FIG 9).

FIG 3: Das Herstellverfahren für die erste und zweite Ausführungsform geht von einem Silizium-Halbleitersubstrat 1 mit dem Isolationsbereich 11 und einem dünnen Gate-Dielektrikum oder Tunneldielektrikum 4 an seiner Oberfläche aus. Es wird als erste leitende Schicht 5 ganzflächig Polvsilizium in einer Dicke von etwa 200 nm aufgebracht, darauf wird eine aus Nitrid bestehende Kartmaske 6 als erste Maske erzeugt. Über die Schichtdicke der ersten Maske wird die Koppelkapazität eingestellt. In der ersten Ausführungsform weist die erste Maske 6 eine in der zweiten Richtung quer über das aktive Gebiet verlaufende Bahn der Breite F auf, die den gleichen Verlauf wie das Controlgate 10 in FIG 1 hat. In der zweiten Ausführungsform weist sie einen auf den Kanalbereich justierte Insel auf, die lageidentisch mit dem Floatinggate 5 in FIG 2 ist und die vorzugsweise die Größe FxF hat. Die Polvsiliziumschicht 5 wird mit dieser ersten Maske geätzt.

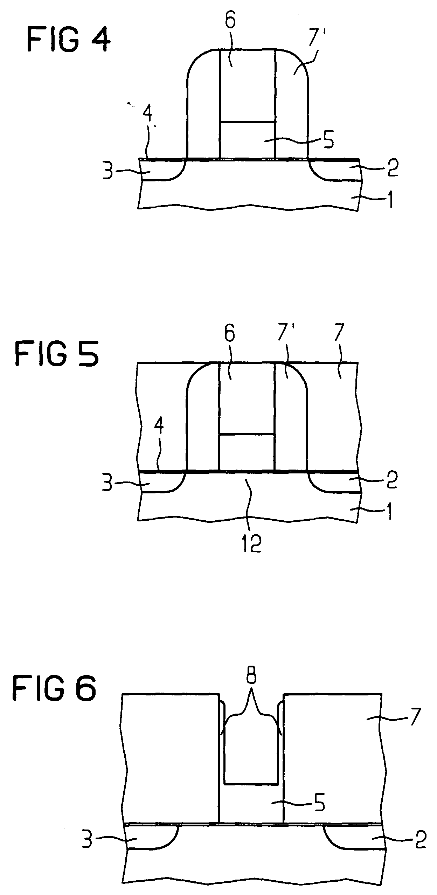

FIG 4: An den Seitenwänden der ersten leitenden Schicht 5 und der ersten Maske 6 kann nun in bekannter Weise ein isolierender Spacer 7' erzeugt werden, um dann durch geeignete Implantation die dotierten Gebiete Source 2 und Drain 3 in aktivem Gebiet zu erzeugen. Der Substratbereich zwischen Source und Drain ist der Kanalbereich 12. Der Spacer 7' besteht aus einem anderen Material als die erste Maske 6, beispielsweise aus Oxid.

FIG 5: Es wird ganzflächig eine erste isolierende Schicht 7 aufgebracht, die vorzugsweise aus demselben Material wie der Spacer 7' besteht und vom Material der ersten Maske 6 verschieden sein muß. Die erste isolierende Schicht 7, beispielsweise eine Teos-Schicht, wird planarisiert, so daß die Oberfläche der ersten Maske 6 freiliegt. Dazu wird ein bekanntes Planarisierungsverfahren eingesetzt, beispielsweise ein Schleifverfahren (CMP).

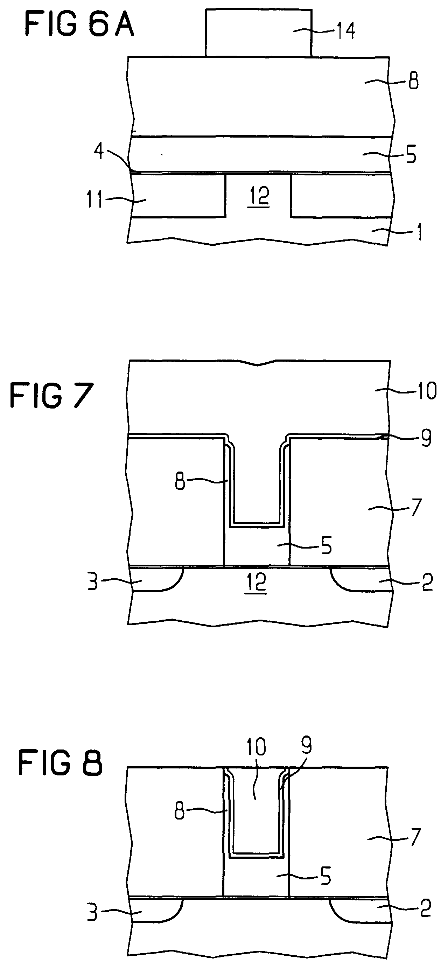

FIG 6: Die erste Maske 6 wird mit einem zur ersten Isolationsschicht 7 und zum Spacer 7' selektiven Ätzprozeß entfernt, so daß in der ersten Isolationsschicht ein Loch entsteht, welches in der ersten Ausführungsform grabenförmig und in der zweiten Ausführungsform topfförmig ist. Der Spacer 7' ist in den folgenden Figuren nicht mehr getrennt von der ersten Isolationsschicht dargestellt. Es wird ganzflächig Polysilizium in einer Dicke von etwa 50 nm als zweite leitende Schicht 8 aufgebracht, so daß die Seitenwände und der Boden des Loches bedeckt sind. Anschließend wird die zweite leitende Schicht anisotrop zurückgeätzt, so daß an den Seitenwanden des Lochs leitende Spacer 8 verbleiben, die mit der ersten leitenden Schicht 5 verbunden sind. Bei der ersten Ausführungsform ist nun ein U-förmiges Floatinggate 5, 8 gebildet, das sich in der ersten Richtung als Bahn erstreckt, so daß beispielsweise die Floatinggates benachbarter Zellen in der ersten Richtung miteinander verbunden sind. Bei der zweiten Ausführungsform ist ein topfförmiges Floatinggate 5, 8 gebildet, das lateral rundum durch das Teos 7 isoliert ist. FIG 6a zeigt einen Querschnitt entlang der zweiten Richtung am Rand des Floatinggates 5 (durch den leitenden Spacer 8) bei der ersten Ausführungsform. Um die hier notwendige Trennung benachbarter Floatinggates zu erreichen, wird auf die Oberfläche eine zweite Maske 14 aufgebracht, die die Ausdehnung des Floatinggates in der zweiten Richtung definiert. Vorzugsweise weist die zweite Maske eine Bahn der Breite 5/3 F auf, die in der ersten Richtung verläuft. Mit der zweiten Maske 14 werden die zweite leitende Schicht 8 und die erste leitende Schicht 5 geätzt, so daß ein isoliertes Floatinggate 5, 8 gebildet wird. An das Floatinggate schließt sich in der zweiten Richtung dann ein Graben in der ersten isolierenden Schicht 7 an, der vertikal bis zum Isolationsgebiet 11 bzw. bis zum Gatedielektrikum 4 reicht.

FIG 7: Bei beiden Ausführungsformen wird nun als Dielektrikum 9 eine ONO-Schicht aufgebracht. Dann wird Polysilizium als dritte leitende Schicht 10 abgeschieden, so daß das Loch vollständig aufgefüllt wird.

FIG 8: Bei der ersten Ausführungsform kann die dritte leitende Schicht 10 ganzflächig zurückgeätzt werden, so daß sie lediglich im Graben, d.h. innerhalb des Floatinggates 5, 8 oder innerhalb der ersten isolierenden Schicht 7 verbleibt. Das Controlgate 10 verläuft dann in den Graben, der ursprünglich durch die erste Maske definiert war, und verbindet die in der zweiten Richtung benachbarten Zellen.

FIG 9: Bei der zweiten Ausführungsform muß die dritte leitende Schicht 10 zu einer in der zweiten Richtung verlaufenden Bahnen oberhalb der ersten isolierenden Schicht strukturiert werden, da das Controlgate über die vor und hinter der Zeichenebene liegenden Seitenwände des Floatinggates hinweggeführt werden muß. Es ist auch möglich, zunächst das topfförmige Loch wie in FIG 8 mit der dritten leitenden Schicht aufzufüllen und ggf. zu planarisieren und dann eine weitere leitende Schicht 10' abzuscheiden und diese zu einer durchgehenden Leitbahn zu strukturieren, die benachbarte Zellen miteinander verbindet. Die weitere leitende Schicht und/oder die dritte leitende Schicht können aus Polvsilizium, Wolfram, Wsi oder TiN bestehen.

FIG 10: Bei der dritten Ausführungsform ist das Floatinggate U-förmig, wobei die Seitenwände 8 an den in der zweiten Richtung gegenüberliegenden Seiten sich nach oben erstrecken.

FIG 11a, b: Für die Herstellung wird von einem Silizium-Substrat 1 mit einem Isolationsgebiet 11 und einem Gatedielektrikum 4 an seiner Oberfläche ausgegangen. Es werden eine erste leitende Schicht 5 aus Polysilizium und eine beispielsweise aus Siliziumoxid bestehende erste Maske 6 aufgebracht. Die erste Maske weist eine in der ersten Richtung verlaufende Bahn vorzugsweise der Breite F auf, die über das aktive Gebiet verläuft. Mit der ersten Maske 6 wird das Polysilizium 5 geätzt. Ein Justierfehler würde dazu führen, daß die Schichtstruktur 5, 6 in FIG 11b seitlich versetzt wird, also das Isolationsgebiet 11 etwas überlappt und das Kanalgebiet 12 teilweise freiläßt. Dieser freiliegende Teil wird aber im folgenden Schritt mit der ersten isolierenden Schicht 7 abgedeckt und ist daher unschädlich.

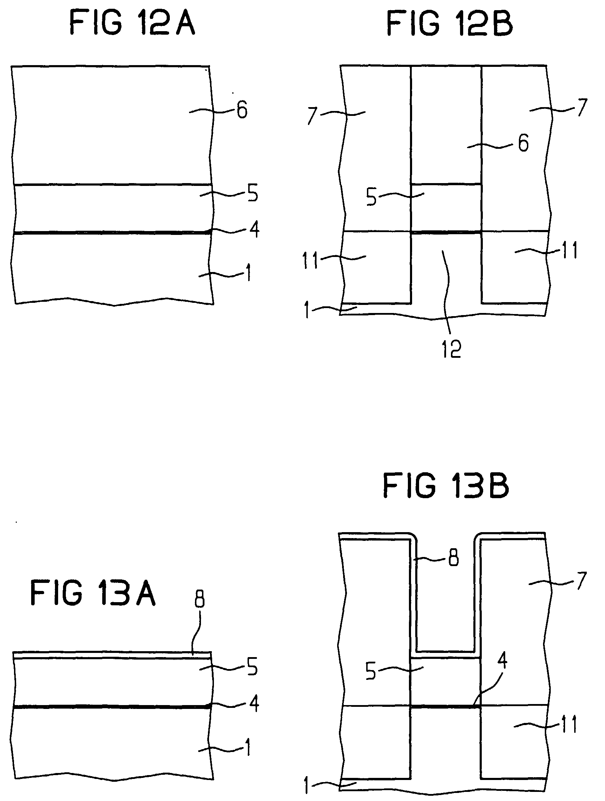

FIG 12: Als erste isolierende Schicht 7 wird ganzflächig Siliziumnitrid aufgebracht und beispielsweise mittels CMP planarisiert, bis die Oberfläche der ersten Maske 6 freiliegt. Die Nitridschicht bedeckt dann das Isolationsgebiet 11 und bei einer Dejustierung der ersten Maske 6 gegenüber dem aktiven Gebiet auch einen Randbereich des Kanalbereichs 12.

FIG 13: Das Oxyd 6 wird selektiv zu dem umgebenden Nitrid 7 geätzt, so daß ein in der ersten Richtung verlaufender Graben entsteht, dessen Seitenwände von Nitrid 7 und dessen Boden von Polysilizium 5 gebildet werden. Dann wird Polysilizium als zweite leitende Schicht 8 ganzflächig aufgebracht.

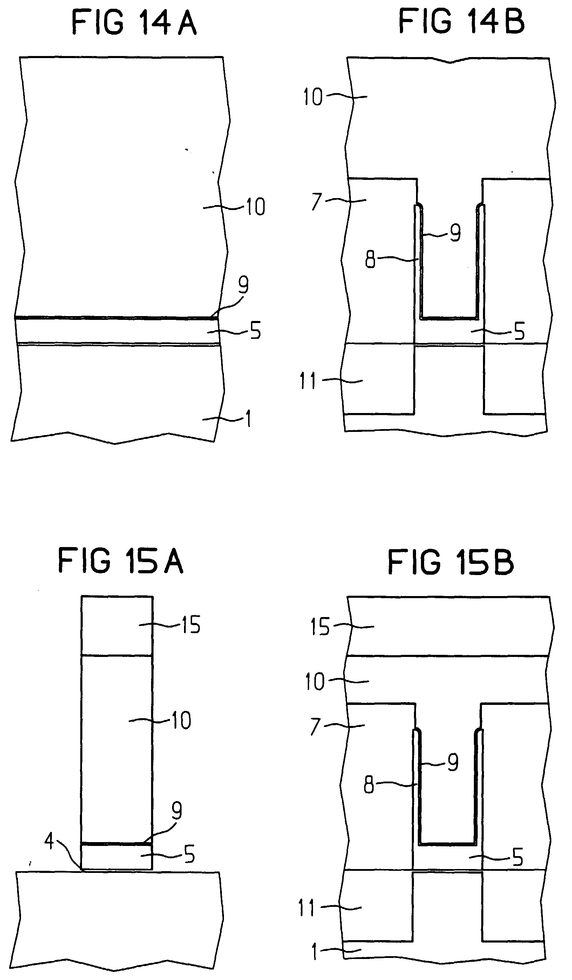

FIG 14: Nach einer ganzflächigen Rückätzung des Polysiliziums sind die Seitenwände des Grabens noch bis zu einer durch die Ätzzeit vorgegebene Höhe mit einem Polysiliziumspacer 8 bedeckt. Der Boden ist mit dem Polysilizium der ersten leitenden Schicht 5 bedeckt. Dann werden ganzflächig eine ONO-Schicht als Dielektrikum 9 und Polysilizium als dritte leitende Schicht 10 aufgebracht, so daß der Graben gefüllt ist. Das Polysilizium 10 kann nun mit CMP behandelt werden, wobei es aber über der ersten Isolationsschicht 7 in einer als Leitbahn ausreichenden Dicke beispielsweise 200 nm, stehen bleibt. Alternativ kann auch das gesamte oberhalb der Grabenoberkante liegende Polysilizium 10 entfernt werden und dann eine weitere leitende Schicht aufgebracht werden.

FIG 15: Mit einer weiteren Maske 15 werden dann die dritte leitende Schicht 10, das Dielektrikum 9 und die erste leitende Schicht 5, geätzt. Die Maske definiert die Dimension und die Lage des Controlgates, verläuft also bahnförmig in der zweiten Richtung. Gleichzeitig wird das Ausmaß des Floatinggates in der ersten Richtung damit festgelegt. Die Bahnbreite beträgt vorzugsweise F. Das Floatinggate entsteht genau im Kreuzungsbereich der beiden Masken 6, 15, dadurch ist auch der Kanalbereich 12 definiert. Eine Dejustierung der weiteren Maske 15 ist unkritisch, da Source und Drain erst anschließend unter Verwendung dieser Maske implantiert werden.

FIG 16: An den Seitenwänden des erzeugten Controlgates werden in bekannter Weise isolierende Spacer 16 erzeugt, dann werden Source und Drain 2, 3 implantiert.

Bei allen drei Ausführungsformen wird die Zelle in bekannter Weise fertiggestellt, insbesondere durch Isolation des Controlgates und Anschlußmetallisierung von Source und Drain.

## Patentansprüche

1. Halbleiterstruktur mit
- einem ersten (2) und einem zweiten dotierten Gebiet (3) eines zweiten Leitungstyps in einem Halbleitersubstrat (1) des ersten Leitungstyps, die durch einen Kanalbereich (12) im Halbleitersubstrat voneinander getrennt sind, wobei die geometrische Verbindungslinie zwischen den dotierten Gebieten (2, 3) eine erste Richtung definiert,
- einem Isolationsgebiet (11), das das erste und zweite dotierte Gebiet und den Kanalbereich lateral umgibt,
- einem Floatinggate (5, 8), das isoliert auf der Oberfläche des Kanalbereichs (12) angeordnet ist,
- einem Controlgate (10), das auf der dem Kanalbereich abgewandten Seite des Floatinggates angeordnet ist, und durch ein Dielektrikum (9) vom Floatinggate isoliert ist und in einer zweiten Richtung verläuft,
**dadurch gekennzeichnet,** daß die an das Dielektrikum (9) angrenzenden Oberflächen von Floatinggate (5, 8) und Controlgate (10) einen Abschnitt aufweisen, der im wesentlichen senkrecht zur Oberfläche des Kanalbereichs verläuft.

2. Halbleiterstruktur nach Anspruch 1,
**dadurch gekennzeichnet,** daß das Dielektrikum (9) mindestens einen Teil der Seitenwände des Controlgates (10) bedeckt, und das Floatinggate (5, 8) sich entlang dieses Teils der Seitenwand erstreckt.

3. Halbleiterstruktur nach Anspruch 2,
**dadurch gekennzeichnet,** daß das Floatinggate (5, 8) U-förmig ausgebildet ist, und das Controlgate (10) im Innern des U-förmigen Floatinggates angeordnet ist.

4. Halbleiterstruktur nach einem der Ansprüche 1 bis 3,
**dadurch gekennzeichnet,** daß das Floatinggate bei Berücksichtigung von Justiertoleranzen lediglich den Kanalbereich (12) sicher bedeckt.

5. Halbleiterstruktur nach einem der Ansprüche 1 bis 4,
**dadurch gekennzeichnet,** daß
die vertikale Ausdehnung des Controlgates (10) über dem Isolationsgebiet (11) gleich der vertikalen Ausdehnung des Floatinggates (5, 8) und des Controlgates (10) über dem Kanalbereich (12) ist.

6. Halbleiterstruktur nach einem der Ansprüche 1 bis 2,
**dadurch gekennzeichnet,** daß
das Floatinggate (5, 8) topfförmig ausgebildet ist und das Controlgate (10) zumindest teilweise innerhalb des topfförmigen Floatinggates angeordnet ist.

7. Halbleiterstruktur nach einem der Ansprüche 1 bis 2,,
**dadurch gekennzeichnet,** daß
das Floatinggate U-förmig ausgebildet ist, wobei die in der zweiten Richtung gegenüberliegenden Seitenwände des Floatinggates sich nach oben erstrecken, und das Controlgate (10) zumindest teilweise innerhalb des U-förmigen Floatinggates angeordnet ist.

8. Halbleiterstruktur nach einem der Ansprüche 1, 2,6, 7,
**dadurch gekennzeichnet,** daß
die Ausdehnung des Floatinggates in der ersten und zweiten Richtung jeweils gleich der minimal herstellbaren Strukturfeinheit F ist.

9. Herstellverfahren für eine Halbleiterstruktur nach einem der Ansprüche 1 bis 8,
bei dem zur Herstellung des Floatinggates
(a) eine erste leitende Schicht (5) auf die isolierte Substratoberfläche aufgebracht und mit einer ersten Maske (6) strukturiert wird,
(b) eine erste isolierende Schicht (7) aufgebracht wird,
(c) die Oberfläche der ersten Maske freigelegt wird und die erste Maske (6) entfernt wird, so daß ein Loch in der ersten isolierenden Schicht (7) entsteht, das die Oberfläche der ersten leitenden Schicht (5) freilegt,
(d) eine zweite leitende Schicht auf den freiliegenden Oberflächen im Loch aufgebracht wird,
bei dem das Dielektrikum (9) auf den leitenden Oberflächen aufgebracht wird,
bei dem zur Herstellung des Controlgates (10) eine dritte leitende Schicht auf dem Dielektrikum (9) aufgebracht wird, die das Loch auffüllt, und aus der dritten leitenden Schicht oder einer weiteren leitenden Schicht (10') eine das Controlgate bildende, in der zweiten Richtung verlaufende Bahn hergestellt wird.

10. Herstellverfahren nach Anspruch 9, bei dem in Schritt (a) die erste leitende Schicht (5) mit Hilfe der ersten Maske (6) zu einer Bahn strukturiert wird, die in der zweiten Richtung über den Kanalbereich verläuft und bei dem nach Schritt (d) die zweite leitende Schicht und die darunterliegende erste leitende Schicht mit Hilfe einer zweiten Maske, die den Kanalbereich sicher abdeckt, geätzt werden.

11. Herstellverfahren nach einem der Ansprüche 9 bis 10, bei dem nach der Strukturierung der ersten leitenden Schicht (5) an den Seiten der ersten Maske und der ersten leitenden Schicht isolierende Spacer (7') gebildet werden und die Justierung der dotierten Gebiete (2, 3) erfolgt.

12. Herstellverfahren nach Anspruch 9, bei dem in Schritt (a) die erste leitende Schicht (5) mit Hilfe der ersten Maske zu einer Bahn strukturiert wird, die in der ersten Richtung über das aktive Gebiet verläuft und bei dem zur Herstellung des Controlgates mit Hilfe einer weiteren Maske (15), die dem herzustellenden Controlgate entspricht, die dritte leitende Schicht (10), das Dielektrikum (9) und die erste leitende Schicht (5) geätzt werden.

13. Herstellverfahren nach einem der Ansprüche 9 bis 12, bei dem auf der dritten leitenden Schicht (10) eine weitere leitende Schicht (10') hergestellt wird, die als Teil des Controlgates benachbarte Zellen miteinander verbindet.

14. Herstellverfahren nach einem der Ansprüche 9 bis 13, bei dem die erste Maske (6) aus Siliziumnitrid und die erste isolierende Schicht (7) aus Siliziumoxid erzeugt werden, oder die erste Maske aus Siliziumoxid und die erste isolierende Schicht aus Siliziumnitrid erzeugt werden.

15. Herstellverfahren nach einem der Ansprüche 9 bis 14, bei dem die Oberfläche der ersten Maske (6) durch ein Planarisierungsverfahren freigelegt wird.

16. Herstellverfahren nach einem der Ansprüche 9 bis 15, bei dem die erste (5) und die zweite leitende Schicht (8) aus demselben Material bestehen.

17. Herstellverfahren nach einem der Ansprüche 9 bis 16, bei dem die dritte leitende Schicht (10) aus Polysilizium, WSi TiN oder aus Wolfram besteht.

18. Herstellverfahren nach einem der Ansprüche 9 bis 17, bei dem die Koppelkapazität zwischen Floatinggate (5, 8) und Controlgate (10) mit Hilfe der Schichtdicke der ersten Maske (6) eingestellt wird.
